# EUROPEAN PATENT APPLICATION

(11) **EP 2 858 094 A1**
(43) Date of publication of application: **08.04.2015**
(21) Application number: 13798034.8
(22) Date of filing: 27.05.2013
(51) Int. Cl.: H01L 21/205, C23C 16/34, C30B 25/18, C30B 29/38, H01L 33/16, H01L 33/32

(54) **SEMICONDUCTOR LAMINATE STRUCTURE AND SEMICONDUCTOR ELEMENT**

(30) Priority: 01.06.2012 JP 2012125979
(71) Applicant: Tamura Corporation, Tokyo 178-8511 (JP); Koha Co., Ltd., Tokyo 178-8511 (JP)
(72) Inventor: IIZUKA, Kazuyuki, Tokyo 178-8511 (JP); WATANABE, Shinya, Tokyo 178-8511 (JP); KOSHI, Kimiyoshi, Tokyo 1788511 (JP); WAKIMOTO, Daiki, Tokyo 178-8511 (JP); YAMASHITA, Yoshihiro, Tokyo 178-8511 (JP); SATO, Shinkuro, Tokyo 178-8511 (JP)
(74) Representative: Betten & Resch
(86) International application number: PCT/JP2013/064628
(87) International publication number: WO 2013/180058

(57) **Abstract**

Provided is a semiconductor laminate structure having a Ga₂O₃ substrate and a nitride semiconductor layer with high crystal quality on the Ga₂O₃ substrate, and also provided is a semiconductor element containing this semiconductor laminate structure. In one embodiment, this semiconductor laminate structure (**1**) is provided with a β-Ga₂O₃ substrate (**2**) comprising β- Ga₂O₃ crystal in which the surface inclined from the (-**201**) surface in the [**102**] direction is the primary surface (**2**a), and a nitride semiconductor layer (**4**) comprising an AlₓGa_{y}In_{z}N (**0**≤x≤**1**, **0**≤y≤**1**, **0**≤z≤**1**, x+y+z=**1**) crystal formed by epitaxial crystal growth on the primary surface (**2**a) of the β-Ga₂O₃ substrate (**2**).

## Description

### [Technical Field]

The invention relates to a semiconductor laminate structure and a semiconductor element.

### [Background Art]

Conventionally, optical device substrates having a Ga₂O₃ substrate and a GaN layer grown on the Ga₂O₃ substrate are known (see, e.g., PTL **1**). In PTL 1, the GaN layer is grown on the Ga₂O₃ substrate having a (**100**) plane as a principal surface.

### [Citation List]

### [Patent Literature]

### [PTL 1]

JP-A-**2009-227545**

### [Summary of Invention]

### [Technical Problem]

For a laminate structure having a Ga₂O₃ substrate and a GaN layer grown thereon, it is important to grow a high-quality GaN crystal on the Ga₂O₃ substrate in order to reduce the leakage current of a device formed on the GaN layer and to improve the reliability of device characteristics.

It is an object of the invention to provide a semiconductor laminate structure that includes a Ga₂O₃ substrate and a nitride semiconductor layer with high crystal quality on the Ga₂O₃ substrate, as well as a semiconductor element including the semiconductor laminate structure.

### [Solution to Problem]

According to one embodiment of the invention, a semiconductor laminate structure set forth in [1] to [5] below is provided.

[1] A semiconductor laminate structure, comprising:
a substrate comprising a β-Ga₂O₃ crystal having a principal surface inclined from a (-**201**) plane to a [**102**] direction; and
a nitride semiconductor layer comprising an AlₓGa_{y}In_{z}N (**0**≤x≤**1**, **0**≤y≤**1**, **0**≤z≤**1**, x+y+z=**1**) crystal formed by epitaxial crystal growth on the principal surface of the substrate.

[2] The semiconductor laminate structure according to [1], wherein the principal surface is a surface inclined at an off-angle of **0.5**° to **2.5**° to the [**102**] direction and **-1.0**° to **1.0**° to a [**010**] direction from the (-**201**) plane.

[3] The semiconductor laminate structure according to [2], wherein the principal surface is a surface inclined at an off-angle of **1.0**° to **2.0**° to the [**102**] direction and **-0.5**° to **0.5**° to the [**010**] direction from the (-**201**) plane.

[4] The semiconductor laminate structure according to any one of [1] to [3], comprising a buffer layer comprising an AlₓGa_{y}In_{z}N (**0**≤x≤**1**, **0**≤y≤**1**, **0**≤z≤**1**, x+y+z=**1**) crystal between the substrate and the nitride semiconductor layer.

[5] The semiconductor laminate structure according to any one of [1] to [3], wherein the nitride semiconductor layer comprises a GaN crystal.

Also, according to another embodiment of the invention, a semiconductor element set forth in [6] below is provided.

[6] A semiconductor element, comprising the semiconductor laminate structure according to any one of [1] to [3].

### [Advantageous Effects of Invention]

According to one embodiment of the invention, a semiconductor laminate structure can be provided that includes a Ga₂O₃ substrate and a nitride semiconductor layer with high crystal quality on the Ga₂O₃ substrate, as well as a semiconductor element including the semiconductor laminate structure

### [Brief Description of Drawings]

[**FIG.1**]

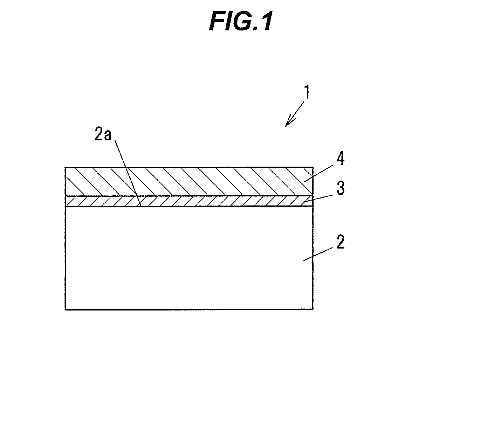

   **FIG.1** is a vertical cross-sectional view showing a semiconductor laminate structure in a first embodiment.
[**FIG.2**]

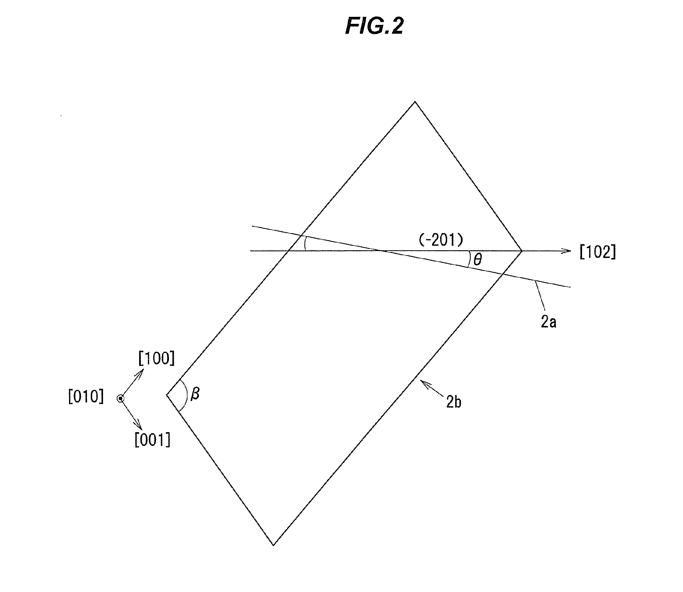

   **FIG.2** is a conceptual diagram illustrating an orientation relationship between a unit cell of β-Ga₂O₃ crystal and a principal surface of a β-Ga₂O₃ substrate.
[**FIG.3A**]

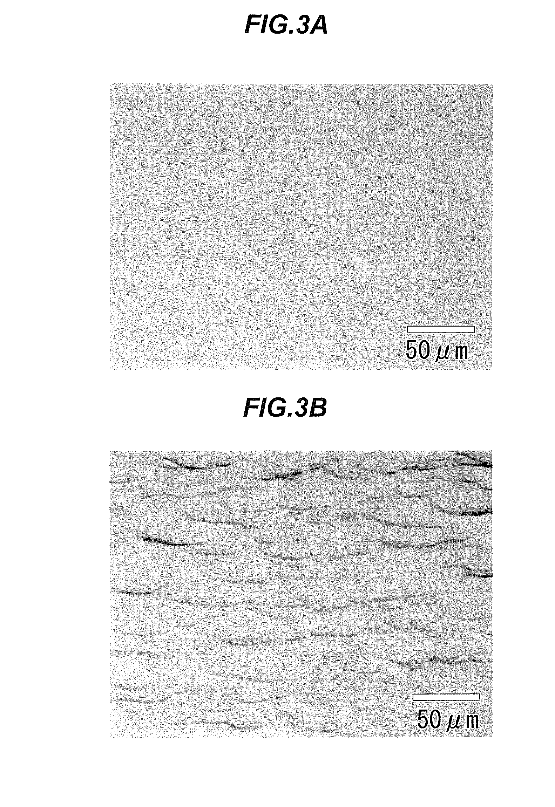

   **FIG.3A** is a surface photograph of an example of a nitride semiconductor layer in the present embodiment.
[**FIG.3B**]
   **FIG.3B** is a surface photograph of a nitride semiconductor layer in Comparative Example.
[**FIG.4A**]

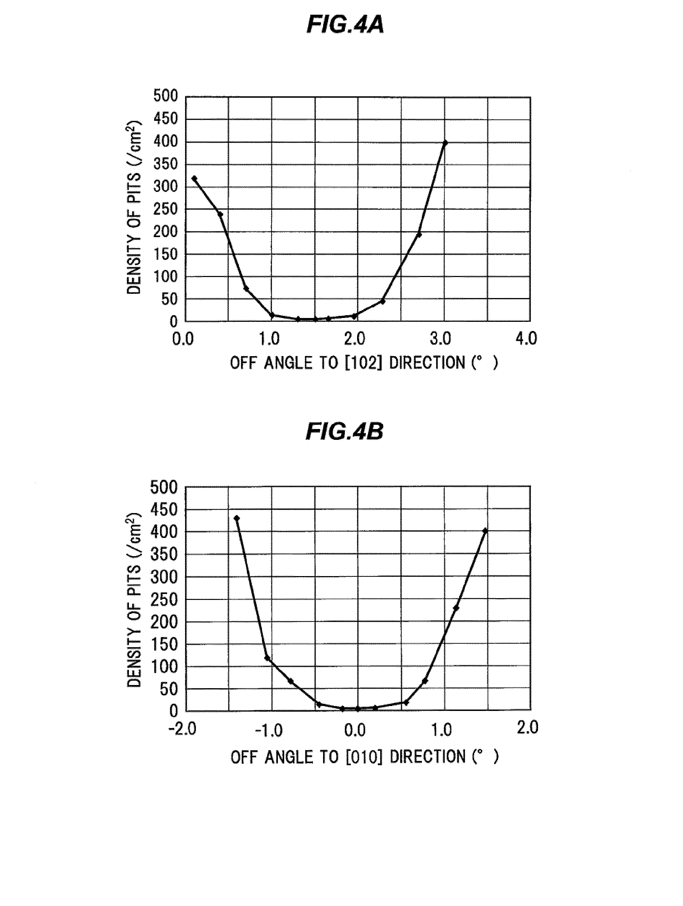

   **FIG.4A** is a graph showing a relation between the magnitude of off-angle of the principal surface of the β-Ga₂O₃ substrate and a density of pits on a surface of the nitride semiconductor layer.
[**FIG.4B**]
   **FIG.4B** is a graph showing a relation between the magnitude of off-angle of the principal surface of the β-Ga₂O₃ substrate and a density of pits on a surface of the nitride semiconductor layer.
[**FIG.5**]

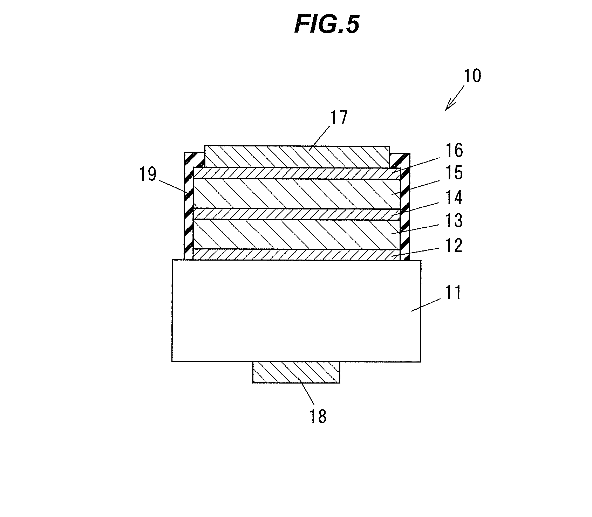

   **FIG.5** is a vertical cross-sectional view showing an LED element in a second embodiment.

### [Description of Embodiments]

### [First embodiment]

### (Configuration of semiconductor laminate structure)

**FIG.1** is a vertical cross-sectional view showing a semiconductor laminate structure **1** in the first embodiment. The semiconductor laminate structure **1** has a β-Ga₂O₃ substrate **2** and a nitride semiconductor layer **4** which is formed on a principal surface **2**a of the β-Ga₂O₃ substrate **2** by epitaxial crystal growth. It is preferable to also provide a buffer layer **3** between the β-Ga₂O₃ substrate **2** and the nitride semiconductor layer **4** as shown in **FIG.1** to reduce lattice mismatch between the β-Ga₂O₃ substrate **2** and the nitride semiconductor layer **4**.

The β-Ga₂O₃ substrate **2** is formed of a β-Ga₂O₃ crystal. The β-Ga₂O₃ substrate **2** may contain a conductive impurity such as Si. The thickness of the β-Ga₂O₃ substrate **2** is, e.g., **400** µm.

The buffer layer **3** is formed of an AlₓGa_{y}In_{z}N (**0**≤x≤**1**, **0**≤y≤**1**, **0**≤z≤**1**, x+y+z=**1**) crystal. On the β-Ga₂O₃ substrate **2**, the buffer layer **3** may be formed in an island pattern or in the form of film. The buffer layer **3** may contain a conductive impurity such as Si.

In addition, among AlₓGa_{y}In_{z}N (**0**≤x≤**1**, **0**≤y≤**1**, **0**≤z≤**1**, x+y+z=**1**) crystals, an AlN crystal (x=**1** y=z=**0**) is particularly preferable to form the buffer layer **3**. When the buffer layer **3** is formed of the AlN crystal, adhesion between the β-Ga₂O₃ substrate **2** and the nitride semiconductor layer **4** is further increased. The thickness of the buffer layer **3** is, e.g., **1** to **5** nm.

The buffer layer **3** is formed on the principal surface **2**a of the β-Ga₂O₃ substrate **2** by, e.g., epitaxially growing an AlₓGa_{y}In_{z}N (**0**≤x≤**1**, **0**≤y≤**1**, **0**≤z≤**1**, x+y+z=**1**) crystal at a growth temperature of about **370** to **500°C**.

The nitride semiconductor layer **4** is formed of an AlₓGa_{y}In_{z}N (**0**≤x≤**1**, **0**≤y≤**1**, **0**≤z≤**1**, x+y+z=**1**) crystal and is particularly preferably formed of a GaN crystal (y=**1** x=z=**0**) from which a high-quality crystal is easily obtained. The thickness of the nitride semiconductor layer **4** is, e.g., **5** µm. The nitride semiconductor layer **4** may contain a conductive impurity such as Si.

The nitride semiconductor layer **4** is formed on the principal surface **2**a of the β-Ga₂O₃ substrate **2** via the buffer layer **3** by, e.g., epitaxially growing an AlₓGa_{y}In_{z}N (**0**≤x≤**1**, **0**≤y≤**1**, 0≤z≤**1**, x+y+z=**1**) crystal at a growth temperature of about **1000**°C.

The principal surface **2**a of the β-Ga₂O₃ substrate **2** is a surface inclined from a (-**201**) plane to the [**102**] direction, i.e., a surface having a normal vector inclined from a normal vector of the (-**201**) plane to the [**102**] direction.

Here, the principal surface **2**a of the β-Ga₂O₃ substrate **2** is preferably a surface inclined at an off-angle of **0.5**° to **2.5**° to the [**102**] direction and **-1.0**° to **1.0**° to the [**010**] direction from the (-**201**) plane, i.e., a surface having a normal vector inclined at **0.5°** to **2.5°** to the [**102**] direction and **-1.0**° to **1.0**° to the [**010**] direction from the normal vector of the (-**201**) plane.

Furthermore, the principal surface **2**a of the β-Ga₂O₃ substrate **2** is more preferably a surface inclined at an off-angle of **1.0**° to **2.0**° to the [**102**] direction and **-0.5**° to **0.5**° to the [**010**] direction from the (-**201**) plane, i.e., a surface having a normal vector inclined **1.0°** to **2.0**° to the [**102**] direction and **-0.5**° to **0.5**° to the [**010**] direction from the normal vector of the (-**201**) plane.

It is possible to obtain the nitride semiconductor layer **4** with high crystal quality by epitaxially growing an AlₓGa_{y}In_{z}N (**0**≤x<**1**, **0**≤y≤**1**, **0**≤z≤**1**, x+y+z=**1**) crystal on the principal surface **2**a of the β-Ga₂O₃ substrate **2** which is a surface inclined from the (-**201**) plane as described above.

**FIG.2** is a conceptual diagram illustrating an orientation relationship between a unit cell of β-Ga₂O₃ crystal and the principal surface **2**a of the β-Ga₂O₃ substrate **2**. θ in **FIG**.2 indicates an off-angle from the (-**201**) plane to the [**102**] direction. The off-angle from the (-**201**) plane to the [**010**] direction is defined as **0**° in **FIG.2**.

A unit cell **2**b in **FIG**.**2** is a unit cell of the β-Ga₂O₃ crystal. The β-Ga₂O₃ crystal has a β-gallia structure belonging to the monoclinic system and typical lattice constants of the β-Ga₂O₃ crystal not containing impurities are a**₀**=**12.23**Å., b₀=**3.04**Å, c₀=**5.80**Å, α=γ=**90°** and β=**103.7**°**.** Here, a**₀**, b**₀** and c**₀** respectively indicate an axis length in the [**100**] direction, that in the [**010**] direction and that in the [**001**] direction.

Off-direction and off-angle of the β-Ga₂O₃ substrate which improve crystal quality of a nitride semiconductor layer in case of forming the nitride semiconductor layer on the β-Ga₂O₃ substrate having a (-**201**) plane as a principal surface are not known so far.

When a nitride semiconductor layer is formed on the (-**201**) plane with no off-angle, an off-angle of the nitride semiconductor layer becomes large, a remarkable wavy morphology (step bunching) appears on the surface and the density of generated pits on the surface of the crystal (pores generated on the surface) increases. As a result, leakage current in a structure formed on the nitride semiconductor, e.g., a light-emitting device structure having a p-n junction, increases and this results in a decrease in reliability.

The present inventors discovered that a difference in an off-angle from the (-**201**) plane between the β-Ga₂O₃ substrate having the (-**201**) plane as a principal surface and the AlₓGa_{y}In_{z}N (**0**≤x≤**1**, **0**≤y≤**1**, **0**≤z≤**1**, x+y+z=**1**) crystal grown on the principal surface is about **1.5**° to the [**102**] direction and about **0**° to the [**010**] direction. Then, it was found that this difference in the off-angle is a cause of low crystal quality of the nitride semiconductor layer and it is possible to improve the crystal quality of the nitride semiconductor layer by adjusting the principal surface of the β-Ga₂O₃ substrate to have an off-angle corresponding to the off-angle difference.

**FIG**.**3A** is a surface photograph of an example of the nitride semiconductor layer **4** in the present embodiment. **FIG.3B** is a surface photograph of a nitride semiconductor layer in Comparative Example.

The nitride semiconductor layer **4** shown in **FIG**.**3A** is formed of a Si-doped GaN crystal having a thickness of **6** µm and is obtained by growing an AlN crystal on the β-Ga₂O₃ substrate **2** having a surface inclined at an off-angle of **1.5**° to the [**102**] direction and 0° to the [**010**] direction from the (-**201**) plane as the principal surface **2**a at a growth temperature of **450**°C to form the buffer layer **3**, and then growing a Si-doped GaN crystal thereon at a growth temperature of **1050**°C.

The nitride semiconductor layer shown in **FIG.3B** is formed of a Si-doped GaN crystal having a thickness of **6** µm and is obtained by growing an AlN crystal on a β-Ga₂O₃ substrate having the (-**201**) plane with no off-angle as a principal surface at a growth temperature of **450**°C to form a buffer layer, and then growing a Si-doped GaN crystal thereon at a growth temperature of **1050**°C.

Although a difference in manufacturing conditions between the nitride semiconductor layer **4** shown in **FIG**.**3A** and the nitride semiconductor layer shown in **FIG.3B** is only that the principal surface of the β-Ga₂O₃ substrate has an off-angle or not, step bunching is not observed on surface morphology of the nitride semiconductor layer **4** of **FIG.3A** whereas step bunching is observed on surface morphology of the nitride semiconductor layer of **FIG.3B****.** In addition, the density of pits is **1.25**/cm² on the surface of the nitride semiconductor layer **4** of **FIG.3A** and is **420**/cm² on the surface of the nitride semiconductor layer **of** **FIG.3B****.**

These results show that the nitride semiconductor layer **4** in the present embodiment shown in **FIG**.**3A** has higher crystal quality than the nitride semiconductor layer in Comparative Example shown in **FIG.3B****.**

**FIGS.4A** and **4B** are graphs showing a relation between the magnitude of off-angle of the principal surface **2**a of the β-Ga₂O₃ substrate **2** and the density of pits on the surface of the nitride semiconductor layer **4**. The horizontal axis indicates the off-angle from the (-**201**) plane to the [**102**] direction in **FIG.4A** and the off-angle from the (-**201**) plane to the [**010**] direction in **FIG.4B**. The vertical axis indicates the density of pits on the surface of the nitride semiconductor layer **4** in **FIGS.4A** and **4B**.

The nitride semiconductor layer **4** used for measurements **of** **FIGS.4A** and **4B** is formed of a Si-doped GaN crystal having a thickness of **6** µm and is obtained by growing an AlN crystal on the β-Ga₂O₃ substrate **2** at a growth temperature of **450**°C to form the buffer layer **3**, and then growing a Si-doped GaN crystal thereon at a growth temperature of **1050**°C.

**FIG.4A** shows a change in the density of pits on the surface of the nitride semiconductor layer **4** when the off-angle from the (-**201**) plane to the [**010**] direction is fixed to **0**° and the off-angle to the [**102**] direction is changed between **0.0**° and **4.0**°.

As shown in **FIG.4A****,** the density of pits on the surface of the nitride semiconductor layer **4** is the minimum when the off-angle from the (-**201**) plane to the [**102**] direction is **1.5**°.

**FIG.4A** shows that the density of pits is particularly small when the off-angle from the (-**201**) plane to the [**102**] direction is **1.5**°±**0.5**°, i.e., from **1.0**° to **2.0**°. It is also shown that the density of pits is about half or less than the case of having no off-angle (**0**°) when the off-angle from the (-**201**) plane to the [**102**] direction is **1.5**°±**1.0**°, i.e., from **0.5**° to **2.5**°.

Here, given that the semiconductor laminate structure **1** is used for manufacturing, e.g., an LED chip, the density of pits on the nitride semiconductor layer **4** is not more than about **200**/cm² when the off-angle from the (-**201**) plane to the [**102**] direction is from **0.5**° to **2.5**° and it is thus possible to manufacture small LED chips of about **300** µm square with a practical yield. Furthermore, the density of pits on the nitride semiconductor layer **4** is not more than about **20**/cm² when the off-angle from the (-**201**) plane to the [**102**] direction is from **1.0**° to **2.0**° and it is thus possible to manufacture large LED chips of about **1** mm square with a practical yield. The reason why the allowable density of pits is smaller for larger LED chips is that, even if the density of pits in a state of wafer is the same, chips cut into the large size have a high probability of containing more pits.

**FIG.4B** shows a change in the density of pits on the surface of the nitride semiconductor layer **4** when the off-angle from the (-**201**) plane to the [**102**] direction is fixed to **1.5**° and the off-angle to the [**010**] direction is changed between -**2.0**° and **2.0**°.

As shown in **FIG.4B**, the density of pits on the surface of the nitride semiconductor layer **4** is the minimum when the off-angle from the (-**201**) plane to the [**010**] direction is **0.0**°.

**FIG.4B** shows that the density of pits is small when the off-angle from the (-**201**) plane to the [**010**] direction is **0.0**±**1.0**°, i.e., from -**1.0**° to **1.0**°, and the density of pits is particularly small when the off-angle from the (-**201**) plane to the [**010**] direction is **0.0**°±**0.5**°, i.e., from -**0.5**° to **0.5**°.

It is understood from **FIGS.4A** and **4B** that the principal surface **2**a of the β-Ga₂O₃ substrate **2** is preferably a surface inclined at an off-angle of **0.5**° to **2.5**° to the [**102**] direction and -**1.0**° to **1.0**° to the [**010**] direction from the (-**201**) plane, and more preferably a surface inclined at an off-angle of **1.0**° to **2.0**° to the [**102**] direction and -**0.5**° to **0.5**° to the [**010**] direction from the (-**201**) plane in order to obtain the nitride semiconductor layer **4** with high crystal quality. In addition, the same results as shown in **FIGS.4A** and **4B** are obtained also when the nitride semiconductor layer **4** is formed of an AlₓGa_{y}In_{z}N (**0**≤x≤**1**, **0**≤y≤**1**, **0**≤z≤**1**, x+y+z=**1**) crystal other than the GaN crystal.

### [Second embodiment]

### (Configuration of semiconductor element)

The second embodiment is an embodiment of a semiconductor element including the semiconductor laminate structure **1** in the first embodiment. An LED element will be described below as an example of the semiconductor element.

**FIG.5** is a vertical cross-sectional view showing an LED element **10** in the second embodiment. The LED element **10** has a β-Ga₂O₃ substrate **11**, a buffer layer **12** on the β-Ga₂O₃ substrate **11**, an n-type cladding layer **13** on the buffer layer **12**, a light-emitting layer **14** on the n-type cladding layer **13**, a p-type cladding layer **15** on the light-emitting layer **14**, a contact layer **16** on the p-type cladding layer **15**, a p-type electrode **17** on the contact layer **16** and an n-type electrode **18** on a surface of the β-Ga₂O₃ substrate **11** opposite to the buffer layer **12**.

Then, side surfaces of the laminate composed of the buffer layer **12**, the n-type cladding layer **13**, the light-emitting layer **14**, the p-type cladding layer **15** and the contact layer **16** are covered with an insulating film **19**.

Here, the β-Ga₂O₃ substrate **11**, the buffer layer **12** and the n-type cladding layer **13** respectively correspond to the β-Ga₂O₃ substrate **2**, the buffer layer **3** and the nitride semiconductor layer **4** which constitute the semiconductor laminate structure **1** in the first embodiment. The thicknesses of the β-Ga₂O₃ substrate **11**, the buffer layer **12** and the n-type cladding layer **13** are respectively, e.g., **400** µm, **5** nm and **5** µm.

The light-emitting layer **14** is composed of, e.g., three layers of multi-quantum-well structures and a **10** nm-thick GaN crystal film thereon. Each multi-quantum-well structure is composed of an **8** nm-thick GaN crystal film and a **2** nm-thick InGaN crystal film. The light-emitting layer **14** is formed by, e.g., epitaxially growing each crystal film on the n-type cladding layer **13** at a growth temperature of **750**°C.

The p-type cladding layer **15** is, e.g., a **150** nm-thick GaN crystal film containing Mg at a concentration of **5.0**x**10¹⁹**/cm³. The p-type cladding layer **15** is formed by, e.g., epitaxially growing a Mg-containing GaN crystal on the light-emitting layer **14** at a growth temperature of **1000**°C.

The contact layer **16** is, e.g., a **10** nm-thick GaN crystal film containing Mg at a concentration of **1.5**x**10²⁰**/cm³. The contact layer **16** is formed by, e.g., epitaxially growing a Mg-containing GaN crystal on the p-type cladding layer **15** at a growth temperature of **1000**°C.

For forming the buffer layer **12**, the n-type cladding layer **13**, the light-emitting layer **14**, the p-type cladding layer **15** and the contact layer **16**, it is possible to use TMG (trimethylgallium) gas as a Ga raw material, TMI (trimethylindium) gas as an In raw material, (C₂H₅)₂SiH₂ (diethylsilane) gas as a Si raw material, Cp₂Mg (bis(cyclopentadienyl)magnesium) gas as a Mg raw material and NH₃ (ammonia) gas as an N raw material.

The insulating film **19** is formed of an insulating material such as SiO₂ and is formed by, e.g., sputtering.

The p-type electrode **17** and the n-type electrode **18** are electrodes in ohmic contact respectively with the contact layer **16** and the β-Ga₂O₃ substrate **11** and are formed using, e.g., a vapor deposition apparatus.

The buffer layer **12**, the n-type cladding layer **13**, the light-emitting layer **14**, the p-type cladding layer **15**, the contact layer **16**, the p-type electrode **17** and the n-type electrode **18** are formed on the β-Ga₂O₃ substrate **11** in the form of wafer and are then cut into chips of, e.g., **300** µm square in size by dicing, thereby obtaining the LED elements **10**.

The LED element **10** is, e.g., an LED chip configured to extract light on the β-Ga₂O₃ substrate **11** side and is mounted on a CAN type stem using Ag paste.

Characteristics of the LED element **10** in the present embodiment will be described below referring to the results of experiments in which an LED element having the (-**201**) plane with no off-angle as a principal surface was used as Comparative Example.

Firstly, the LED element **10** and the LED element in Comparative Example were respectively mounted on CAN-type stems using Ag paste. Then, current values (a magnitude of leakage current) when applying **2.0**V of forward voltage between electrodes were measured.

As a result, the current value of the LED element **10** was **0.08** µA whereas the current value of the LED element in Comparative Example was **10.20** µA. It was confirmed from this result that occurrence of leakage current is suppressed in the LED element **10**.

Next, **100** mA of forward current was applied to the LED element **10** and to the LED element in Comparative Example and reliability thereof was evaluated by investigating variation in output of light.

As a result, in the LED element **10**, relative output of light after **1000** hours with respect to the initial state was **102.3%** and almost no change was observed. On the other hand, the LED element in Comparative Example went off after about **18** hours.

It is considered that these evaluation results were obtained since the crystal quality of the n-type cladding layer **13** of the LED element **10** is higher than that of the n-type cladding layer of the LED element in Comparative Example.

The n-type cladding layer **13** of the LED element **10** is formed on the β-Ga₂O₃ substrate **11** having a surface inclined at a specific off-angle as a principal surface and thus has excellent crystal quality as shown in the first embodiment. In addition, the light-emitting layer **14**, the p-type cladding layer **15** and the contact layer **16**, which are formed by epitaxial crystal growth on the n-type cladding layer **13** having excellent crystal quality, also have excellent crystal quality. Therefore, the LED element **10** is excellent in leakage current characteristics and reliability.

### (Effects of the embodiment)

According to the first and second embodiments, it is possible to obtain a nitride semiconductor layer with high crystal quality by epitaxially growing an AlₓGa_{y}In_{z}N (**0**≤x≤**1**, **0**≤y≤**1**, 0≤z≤**1**, x+y+z=**1**) crystal on a β-Ga₂O₃ substrate of which principal surface is a surface inclined from the (-**201**) plane. In detail, for example, step bunching on the nitride semiconductor layer is suppressed and the density of pits on the surface is significantly reduced.

In addition, use of the high-crystal-quality nitride semiconductor layer allows a semiconductor element excellent in leakage current characteristics and reliability to be formed.

It should be noted that the invention is not intended to be limited to the above-mentioned embodiments, and the various kinds of modifications can be implemented without departing from the gist of the invention. For example, although, in the second embodiment, an LED element has been described as an example of a semiconductor element including the semiconductor laminate structure of the first embodiment, the semiconductor element is not limited thereto and may be other elements such as transistor.

In addition, the invention according to claims is not to be limited to the above-mentioned embodiments. Further, it should be noted that all combinations of the features described in the embodiments are not necessary to solve the problem of the invention.

### [Industrial Applicability]

A semiconductor laminate structure having a Ga₂O₃ substrate and a nitride semiconductor layer with high crystal quality on the Ga₂O₃ substrate and a semiconductor element including the semiconductor laminate structure are provided.

### [Reference Signs List]

- **1**: semiconductor laminate structure
- **2**: β-Ga₂O₃ substrate
- **3**: buffer layer
- **4**: nitride semiconductor layer
- **10**: LED element

## Claims

1. A semiconductor laminate structure, comprising:
a substrate comprising a β-Ga₂O₃ crystal having a principal surface inclined from a (-**201**) plane to a [**102**] direction; and
a nitride semiconductor layer comprising an AlₓGa_{y}In_{z}N (**0**≤x≤**1**, **0**≤y≤**1**, **0**≤z≤**1**, x+y+z=**1**) crystal formed by an epitaxial crystal growth on the principal surface of the substrate.

2. The semiconductor laminate structure according to claim **1**, wherein the principal surface is a surface inclined at an off-angle of **0.5**° to **2.5**° to the [**102**] direction and -**1.0**° to **1.0**° to a [**010**] direction from the (-**201**) plane.

3. The semiconductor laminate structure according to claim **2**, wherein the principal surface is a surface inclined at an off-angle of **1.0**° to **2.0**° to the [**102**] direction and -**0.5**° to **0.5**° to the [**010**] direction from the (-**201**) plane.

4. The semiconductor laminate structure according to any one of claims **1** to **3**, comprising a buffer layer comprising an AlₓGa_{y}In_{z}N (**0**≤x≤**1**, **0**≤y≤**1**, **0**≤z≤**1**, x+y+z=**1**) crystal between the substrate and the nitride semiconductor layer.

5. The semiconductor laminate structure according to any one of claims **1** to **3**, wherein the nitride semiconductor layer comprises a GaN crystal.

6. A semiconductor element, comprising the semiconductor laminate structure according to any one of claims **1** to **3**.
